# FASCICULE DE BREVET EUROPEEN

(11) **EP 3 603 000 B1**
(45) Date de publication et mention de la délivrance du brevet: **06.01.2021**
(21) Numéro de dépôt: 18713263.4
(22) Date de dépôt: 29.03.2018
(51) Int. Cl.: H04L 29/06

(54) **PROCÉDÉ D'APPRENTISSAGE D'UN CONTEXTE DE COMPRESSION/DÉCOMPRESSION, DISPOSITIF, SYSTÈME ET PRODUIT PROGRAMME D'ORDINATEUR CORRESPONDANTS**
VERFAHREN ZUM LERNEN AUS EINEM KOMPRESSIONS-/ DEKOMPRESSIONSKONTEXT UND ENTSPRECHENDE VORRICHTUNG, SYSTEM UND COMPUTERPROGRAMMPRODUKT
METHOD FOR LEARNING FROM A COMPRESSION/DECOMPRESSION CONTEXT AND CORRESPONDING DEVICE, SYSTEM AND COMPUTER PROGRAM PRODUCT

(30) Priorité: 29.03.2017 FR 1752627
(43) Date de publication de la demande: 05.02.2020
(73) Titulaire: ACKLIO, 35510 Cesson-Sévigné (FR)
(72) Inventeur: MINABURO, Ana, 35510 Cesson Sevigne (FR); PELOV, Alexander, 35200 Rennes (FR)
(74) Mandataire: Marks & Clerk France
(86) Numéro de dépôt international: PCT/EP2018/058086
(87) Numéro de publication internationale: WO 2018/178242

(56) Documents cités:
- MINABURO ACKLIO L TOUTAIN INSTITUT MINES TELECOM A ET AL: "LPWAN Static Context Header Compression (SCHC) for IPv6 and UDP; draft-ietf-lpwan-ipv6-static-context-hc-00 .txt", LPWAN STATIC CONTEXT HEADER COMPRESSION (SCHC) FOR IPV6 AND UDP; DRAFT-IETF-LPWAN-IPV6-STATIC-CONTEXT-HC-00 .TXT, INTERNET ENGINEERING TASK FORCE, IETF; STANDARDWORKINGDRAFT, INTERNET SOCIETY (ISOC) 4, RUE DES FALAISES CH- 1205 GENEVA, SWITZERLAND, 5 décembre 2016 (2016-12-05), pages 1-14, XP015116927,

## Description

### 1 DOMAINE TECHNIQUE

La présente invention se rapporte au domaine de la compression et décompression de données (notamment, mais non exclusivement des données d'en-têtes) échangées via un lien de communication.

Plus précisément, la présente invention se rapporte à un procédé permettant un apprentissage d'un contexte de compression/décompression (comprenant au moins une règle de compression/décompression) utilisé par deux dispositifs, l'un compresseur et l'autre décompresseur, échangeant des données compressées via un tel lien, tout en minimisant les dégradations de débit utile sur le lien en question.

L'invention a de nombreuses applications, notamment mais non exclusivement, dans le domaine de l'internet des objets, les réseaux dédiés aux échanges de données pour de tels objets présentant souvent des débits réduits afin de limiter la consommations de ces objets dans des applications nomades.

Des exemples de ces réseaux sont les réseaux à la base de la technologie SemTech LoRa, SIGFOX, NB-loT, EC-GSM, Cat-M1, Weightless, Ingenu/RPMA, WI-SUN ou toute autre technologie qui possède des caractéristiques similaires.

L'invention peut s'appliquer également aux objets qui communiquent à travers des réseaux à plus courte portée, tels que Bluetooth, Bluetooth LE, IEEE 802.15.4, ZigBee.

Plus généralement, l'invention peut s'appliquer à tout réseau qui pose des contraintes sur le débit de communication, ou qui est amené à connecter des objets (même si ce réseau n'est pas limité en débit).

### 2 ARRIÈRE-PLAN TECHNOLOGIQUE

Présentés comme la « troisième révolution de l'Internet », les objets connectés sont en train de s'imposer dans tous les domaines de la vie quotidienne et de l'entreprise. La plupart de ces objets sont destinés à produire des données grâce à leurs capteurs intégrés afin de fournir des services à valeur ajoutée pour leur propriétaire.

De par les applications visées, ces objets connectés sont pour la plupart nomades. En particulier, ils doivent pouvoir transmettre les données produites, régulièrement ou à la demande, à un utilisateur déporté.

Dans un environnement industriel de tels objets connectés permettent de relever des valeurs de compteur, de déclencher des actionneurs ou de servir de plan de contrôle d'autres réseaux de données.

L'aspect nomade de ces objets s'accompagne souvent d'un besoin en autonomie d'énergie. Or, même basés sur une des technologies radio mobile cellulaire les plus économes en énergie, les objets connectés actuels continuent de présenter une consommation rédhibitoire pour permettre un déploiement à grande échelle à un coût raisonnable.

Face à la problématique de la consommation du lien radio pour de telles applications nomades, de nouvelles technologies radio basse consommation et bas débit dédiées spécifiquement aux réseaux « Internet des Objets », c'est-à-dire des technologies radio pour des réseaux dits LPWAN (pour « Low-Power Wide-Area Networks » en anglais, ou « réseaux à longue portée et basse consommation » en français), sont en train de voir le jour.

Plus particulièrement, deux types de technologies peuvent être distinguées :
- d'un côté, il existe des technologies propriétaires comme par exemple la technologie de la société Sigfox®, ou bien la technologie LoRa®, ou encore la technologie de la société Qowisio®. En pratique, ces technologies non standardisées reposent toutes sur l'utilisation de la bande de fréquences « Industriel, Scientifique et Médical », dite ISM, et sur la réglementation associée à son utilisation. L'intérêt de ces technologies est qu'elles sont déjà disponibles et permettent le déploiement rapide de réseaux sur la base d'investissements limités. En outre, ils permettent le développement d'objets connectés très économes en énergie et à faible coût ;
- d'un autre côté, il existe plusieurs technologies promues par des organismes de normalisation. A titre d'exemple, on peut citer trois technologies en cours de standardisation auprès du 3GPP (pour « 3rd Generation Partnership Project » en anglais) : NB-IoT (pour « Narrow Band - Internet of Things » en anglais), LTE MTC (pour « Long Term Evolution - Machine Type Communication » en anglais) et EC-GPRS (pour « Extended Coverage - General Packet Radio Service » en anglais). Cependant, de telles solutions ne sont pas encore entièrement spécifiées et vont par ailleurs reposer sur des bandes de fréquences licenciées.

Cependant, le point commun à toutes ces technologies reste le faible débit afin de préserver l'autonomie en énergie des objets connectés utilisant ce type de lien radio pour échanger leurs données.

Afin d'optimiser l'usage de la bande passante sur un tel lien radio du type LPWAN, diverses techniques de compression de données sont en cours d'élaboration.

A titre d'exemple, la technique de « compression d'en-têtes à base de contexte », dite SCHC (pour « Static Context Header Compression » en anglais), est en cours de développement au sein de l'IETF (pour « Internet Engineering Task Force » en anglais). Une telle technique est par exemple décrite dans le document de L. Toutain et al. « LPWAN Static Context Header Compression (SCHC) and fragmentation for IPv6 and UDP » (https://datatracker.ietf.org/doc/html/draft-ietf-Ipwan-ipv6-static-context-hc-02).

En effet, la plupart des réseaux LPWAN se caractérisent par l'usage de trames (aussi appelés parfois « paquets ») de données présentant des parties utiles de taille réduite en regard de la taille des en-têtes correspondant. Par ailleurs, les calculs effectués par la plupart des objets connectés se doivent de rester faibles afin de limiter leur consommation en énergie. De la sorte, la technique SCHC propose de compresser/décompresser les en-têtes utilisés par de tels réseaux via l'usage de contextes comprenant un ensemble de règles de compression/décompression connues à la fois de l'émetteur (ou plus précisément du dispositif compresseur) et du récepteur (ou plus précisément du dispositif décompresseur). De telles règles restent simples à appliquer en termes de charge de calcul en associant des valeurs particulières aux champs d'en-têtes en question.

Plus particulièrement, l'émetteur envoie simultanément les données d'en-têtes compressées ainsi que l'identifiant de la règle utilisée pour compresser les données envoyées. Les règles de compression/décompression étant connues du récepteur, ce dernier effectue la décompression des données compressées reçues sur la base de la règle de compression/décompression identifiée par l'identifiant reçu.

Cependant, une telle technique nécessite que les règles soient connues de part et d'autre du lien de communication, i.e. à la fois par l'émetteur et par le récepteur des données compressées.

Pour ce faire, dans certains cas les règles en question sont préalablement définies au sein de chaque dispositif les utilisant. Dans d'autres cas, une phase d'initialisation dans laquelle les règles en question sont transmises d'un des dispositifs les utilisant à l'autre est mise en œuvre, afin que les deux dispositifs utilisent les mêmes règles lors de leurs échanges de données compressées via leur partie émettrice et réceptrice.

Un telle phase d'initialisation est cependant problématique car elle réduit d'autant le débit disponible sur le lien de communication, notamment lorsque celui-ci est du type LPWAN, i.e. à bas débit en pratique.

Par ailleurs, certaines applications peuvent conduire à des caractéristiques dynamiques du flux de données à échanger sur le lien de communication entre les deux dispositifs (par exemple une étiquette caractérisant le flux véhiculé, un numéro de port d'une application source, etc.). De la sorte, un re-paramétrage des règles de compression/décompression peut s'avérer bénéfique afin d'optimiser la compression des en-têtes des trames de données échangées sur le lien de communication en fonction des caractéristiques de ce dernier.

Or, une mise à jour des règles de compression/décompression nécessite là-encore un échange de données supplémentaire, dégradant par là-même le débit disponible pour les données utiles.

Par ailleurs, cet échange de données supplémentaire peut être long du fait du débit limité dans un réseau LPWAN, ce qui limite l'adaptabilité des règles de compression/décompression au flux de données effectif sur le lien de communication. De même, cette durée d'échange de données supplémentaires peut impacter de manière significative les échanges de données utiles en temps réel entre les dispositifs mettant en œuvre les règles en question.

Il existe donc un besoin pour initialiser et/ou mettre à jour les règles de compression/décompression mises en œuvre pour l'échange de données compressées via un lien de communication en minimisant la dégradation de débit de données utiles sur le lien en question.

Il existe également un besoin pour qu'une telle mise à jour se fasse de manière réactive, en minimisant les impacts temps réels sur l'échange de données sur le lien de communication en question.

### 3 RESUME

Dans un mode de réalisation de la technique décrite, il est proposé un procédé d'apprentissage d'un contexte de compression/décompression comprenant au moins une règle de compression/décompression destinée à être utilisée par un dispositif compresseur et un dispositif décompresseur, pour respectivement compresser et décompresser au moins un premier flux de données transmis via au moins un premier lien de communication. Selon un tel procédé, au moins un dispositif, parmi le dispositif compresseur, le dispositif décompresseur et un dispositif tiers, effectue les étapes suivantes :
- analyse d'au moins un deuxième flux de données non compressé, transmis entre le dispositif compresseur et le dispositif décompresseur via au moins un deuxième lien de communication; et
- apprentissage de ladite au moins une règle de compression/décompression, en fonction de ladite analyse ;
l'étape d'apprentissage comprend une modification d'au moins une règle de compression/décompression de base, pour obtenir ladite au moins une règle de compression/décompression comprise dans le contexte de compression/décompression, ladite au moins une règle de compression/décompression de base comprend au moins une description de champ d'adaptation définissant un comportement de compression/décompression pour un champ d'adaptation du au moins un premier flux de données,
et ladite modification comprend, pour chaque règle de compression/décompression de base sélectionnée :
- pour chaque description de champ d'adaptation, une modification d'au moins un attribut de ladite description de champ d'adaptation, en fonction d'une valeur courante dudit champ d'adaptation dans un paquet dudit au moins un deuxième flux de données.

Ainsi, l'invention propose une solution nouvelle et inventive pour l'apprentissage (i.e. l'initialisation et/ou la mise à jour) d'un contexte de compression/décompression comprenant des règles de compression/décompression mises en œuvre par un dispositif compresseur et par un dispositif décompresseur (chacun des dispositifs compresseur et décompresseur pouvant être un dispositif à part entière ou bien être embarqué dans un autre équipement, comme par exemple un objet connecté, un terminal utilisateur du type smartphone ou tablette, une passerelle de réseau ou un cœur de réseau, un serveur ou un ordinateur, etc.).

Pour ce faire, la technique décrite propose d'utiliser un deuxième lien de communication afin d'effectuer l'apprentissage des règles de compression/décompression en question préalablement à leur utilisation pour l'échange d'un premier flux de données via le premier lien de communication.

Ainsi, la bande passante sur le premier lien de communication reste dédiée à l'échange de données utiles.

Par ailleurs, la possibilité d'effectuer l'apprentissage des règles de compression/décompression sans impacter le débit sur le premier lien de communication permet d'envisager une mise à jour plus fréquente des règles en question. De la sorte, une adaptation des règles aux re-paramétrages dynamiques de l'échange de données sur le premier lien de communication devient envisageable.

Enfin, lorsque le deuxième lien de communication présente un débit plus élevé que celui du premier lien de communication, la durée de l'apprentissage du contexte de compression se trouve réduite.

L'apprentissage est effectué de manière sélective sur des règles de compression/décompression particulières (règles sélectionnées) parmi la totalité des règles de base susceptibles d'être mises en œuvre par les dispositifs compresseur et décompresseur.

Le ou les attributs de la règle de compression/décompression dont on veut que le dispositif compresseur et/ou le dispositif décompresseur et/ou le dispositif tiers fasse(nt) l'apprentissage sont mis à jour de manière souple via les informations fournies sur le deuxième lien de communication.

Le ou les attributs de la règle de compression/décompression dont on veut que le dispositif compresseur et/ou le dispositif décompresseur et/ou le dispositif tiers fasse(nt) l'apprentissage sont par exemple mis à jour sur la base de valeurs d'attributs prédéfinies, choisies sélectivement en fonction de la valeur courante (dans le deuxième flux) du champ d'adaptation auquel sont associés les attributs en question.

Selon un mode de réalisation, ledit au moins un champ d'adaptation est un champ d'en-tête d'un paquet du au moins un premier flux de données, le champ d'en-tête véhiculant une information dynamique d'un protocole de communication.

Ainsi, un apprentissage des attributs des règles de compression/décompression associés aux champs d'en-têtes véhiculant un paramètre dynamique, i.e. non connu préalablement à l'établissement de la communication sur le premier lien de communication, est effectué.

Un tel apprentissage permet une adaptation des règles de compression et décompression aux changements de paramétrage dynamiques de la communication entre les dispositifs compresseur et décompresseur.

Selon un mode de réalisation, ledit au moins un attribut de la au moins une description de champ d'adaptation appartient au groupe comprenant :
- une valeur cible dudit champ d'adaptation ;
- un opérateur de comparaison entre ladite valeur cible et une valeur courante dudit champ d'adaptation dans un paquet dudit au moins un premier flux de données, pour délivrer une décision d'appliquer une fonction de compression ou de décompression à ladite valeur courante ; et
- ladite fonction de compression ou de décompression.

Ainsi, lors d'une phase de fonctionnement (postérieure à la phase d'apprentissage définie par le présent procédé), l'application de la règle de compression/décompression, résultant de l'apprentissage, à la valeur effective d'un champ des données (e.g. un champ d'en-tête) afin de délivrer un champ de données compressé ou décompressé, est conditionnée à la comparaison entre la valeur effective en question et une valeur cible associée au champ de données en question par la règle de compression/décompression obtenue après apprentissage.

Une telle compression ou décompression s'effectue alors via la fonction de compression ou décompression associée au champ de données en question par la règle de compression/décompression obtenue après apprentissage.

Selon un mode de réalisation, l'étape d'apprentissage comprend une sélection, en fonction du au moins un deuxième flux de données non compressé, de ladite au moins une règle de compression/décompression de base parmi une pluralité de règles de compression/décompression de base.

Ainsi, l'apprentissage est effectué de manière sélective sur des règles de compression/décompression particulières parmi des règles de base (e.g. des patrons, ou « templates » en anglais, de règles) préalablement implémentées sur le(s) dispositif(s) qui met(tent) en œuvre le procédé d'apprentissage.

Selon un mode de réalisation, chacune des règles de compression/décompression de base comprend au moins une description de champ de référence définissant un comportement de compression/décompression et une valeur cible pour un champ de référence dudit au moins un premier flux de données. Ladite sélection comprend, pour chacune des règles de compression/décompression de base :
- pour chaque description de champ de référence définissant une valeur cible donnée pour un champ de référence donné, une comparaison entre une valeur courante dudit champ de référence donné dans un paquet dudit au moins un deuxième flux de données, et ladite valeur cible donnée ; et
- une décision de sélection ou non sélection de ladite règle de compression/décompression de base, en fonction de ladite comparaison pour chaque description de champ de référence.

Ainsi, une règle de compression/décompression dont on veut que le dispositif compresseur et/ou le dispositif décompresseur et/ou le dispositif tiers fasse(nt) l'apprentissage est identifiée de manière simple et robuste à travers une comparaison effectuée entre la valeur cible et la valeur courante d'un champ de référence des données sur lequel la règle doit s'appliquer pour en effectuer la compression ou décompression.

Selon un mode de réalisation, ledit au moins un champ de référence est un autre champ d'en-tête d'un paquet du au moins un premier flux de données, ledit autre champ d'en-tête véhiculant une information statique du protocole de communication précité.

Ainsi, l'identification de la règle de compression/décompression dont on veut que le dispositif compresseur et/ou le dispositif décompresseur et/ou le dispositif tiers fasse(nt) l'apprentissage se fait via la reconnaissance de la valeur d'un champ d'en-tête véhiculant un paramètre statique permettant d'identifier le destinataire final des données compressées échangées dans le premier flux de données via le premier lien de communication (e.g. le décompresseur, un dispositif dans lequel le décompresseur est embarqué, ou plus particulièrement une application finale à laquelle sont destinées les données après décompression par le décompresseur).

De la sorte, la méthode décrite permet l'apprentissage d'une règle de compression/décompression utilisée spécifiquement pour l'échange de données compressées avec un dispositif destinataire particulier.

Par ailleurs, l'identification de la règle dont on veut faire l'apprentissage se fait de manière robuste suivant un critère prédéfini (i.e. suivant un critère connu préalablement à l'établissement de la communication via le premier lien de communication).

Selon un mode de réalisation, ladite au moins une règle de compression, comprise dans ledit contexte de compression/décompression, est au format SCHC (pour « Static Context Header Compression » en anglais).

Selon un autre mode de réalisation, ledit au moins un premier lien de communication est un lien d'un réseau sans fil à longue portée et basse consommation (LPWAN, pour « Low-Power Wide-Area Network » en anglais).

Par exemple, il s'agit d'un réseau LoRa®, SIGFOX®, NB-IoT (pour « Narrow Band - Internet of Things » en anglais), EC-GPRS (pour « Extended Coverage - General Packet Radio Service » en anglais), LTE (pour « Long Term Evolution » en anglais) cat-M1, Weightless®, Ingenu/RPMA®, WI-SUN, etc.

Selon encore un autre mode de réalisation, ledit au moins un deuxième lien de communication est un lien d'un réseau sans fil cellulaire.

Par exemple, il s'agit d'un lien radio cellulaire 2G/3G/4G, etc.

Selon un mode de réalisation, le dispositif compresseur et le dispositif décompresseur effectuent chacun les étapes d'analyse et d'apprentissage.

De la sorte, on simplifie la mise en œuvre globale d'un tel apprentissage.

Selon un autre mode de réalisation, l'un des dispositifs compresseur et décompresseur effectue les étapes d'analyse et d'apprentissage, et l'autre des dispositifs compresseur et décompresseur reçoit le contexte de compression/décompression résultant desdites étapes d'analyse et d'apprentissage.

Selon encore un autre mode de réalisation, le dispositif tiers effectue les étapes d'analyse et d'apprentissage, et le dispositif compresseur et le dispositif décompresseur reçoivent chacun le contexte de compression/décompression résultant desdites étapes d'analyse et d'apprentissage.

L'invention concerne également un programme d'ordinateur, comprenant des instructions de code de programme pour la mise en œuvre d'un procédé d'apprentissage d'un contexte de compression/décompression, selon l'un quelconque de ses différents modes de réalisation, lorsque ledit programme est exécuté sur un ordinateur.

Dans un autre mode de réalisation de l'invention, il est proposé dispositif d'apprentissage d'un contexte de compression/décompression comprenant au moins une règle de compression/décompression destinée à être utilisée par un dispositif compresseur et un dispositif décompresseur, pour respectivement compresser et décompresser au moins un premier flux de données transmis via au moins un premier lien de communication. Un tel dispositif comprend une machine de calcul reprogrammable ou une machine de calcul dédiée, apte à et configurée pour :
- analyser d'au moins un deuxième flux de données non compressé, transmis entre le dispositif compresseur et le dispositif décompresseur via au moins un deuxième lien de communication ; et
- faire l'apprentissage de ladite au moins une règle de compression/décompression, en fonction de ladite analyse ;
ledit apprentissage comprenant une **modification** d'au moins une règle de compression/décompression de base, pour obtenir ladite au moins une règle de compression/décompression comprise dans ledit contexte de compression/décompression,
ladite au moins une règle de compression/décompression de base comprenant au moins une description de champ d'adaptation définissant un comportement de compression/décompression pour un champ d'adaptation dudit au moins un premier flux de données,
ladite modification comprenant, pour chaque règle de compression/décompression de base sélectionnée :
pour chaque description de champ d'adaptation, une **modification** d'au moins un attribut de ladite description de champ d'adaptation, en fonction d'une valeur courante dudit champ d'adaptation dans un paquet dudit au moins un deuxième flux de données.

Un tel dispositif d'apprentissage d'un contexte de compression/décompression est notamment apte à mettre en œuvre le procédé d'apprentissage d'un contexte de compression/décompression selon la technique décrite (selon l'un quelconque des différents modes de réalisation précités).

Ainsi, les caractéristiques et avantages de ce dispositif sont les mêmes que ceux du procédé d'apprentissage décrit précédemment. Par conséquent, ils ne sont pas détaillés plus amplement.

### 4 LISTE DES FIGURES

D'autres caractéristiques et avantages apparaîtront plus clairement à la lecture de la description suivante de modes de réalisation particuliers de la divulgation, donnés à titre de simples exemples illustratifs et non limitatifs, et des dessins annexés, parmi lesquels :
- la figure 1 illustre un système comprenant un compresseur et un décompresseur selon un mode de réalisation de la technique décrite ;
- la figure 2 illustre les étapes d'un procédé d'apprentissage d'un contexte de compression/décompression selon un mode de réalisation de la technique décrite ; et
- la figure 3 présente un exemple de structure d'un dispositif d'apprentissage permettant la mise en œuvre du procédé de la figure 2.

### 5 DESCRIPTION DETAILLEE

Sur toutes les figures du présent document, les éléments et étapes identiques sont désignés par une même référence.

Le principe général de la technique décrite consiste en un procédé d'apprentissage d'un contexte de compression/décompression comprenant au moins une règle de compression/décompression destinée à être utilisée par un dispositif compresseur et un dispositif décompresseur, pour respectivement compresser et décompresser un premier flux de données transmis via un premier lien de communication. Selon un tel procédé, au moins un dispositif, parmi le dispositif compresseur, le dispositif décompresseur et un dispositif tiers (différent du dispositif compresseur et du dispositif décompresseur), effectue l'apprentissage de la règle de compression/décompression en question en fonction d'un deuxième flux de données non compressé, transmis entre le dispositif compresseur et le dispositif décompresseur via un deuxième lien de communication.

Ainsi, la bande passante sur le premier lien de communication reste dédiée à l'échange de données utiles.

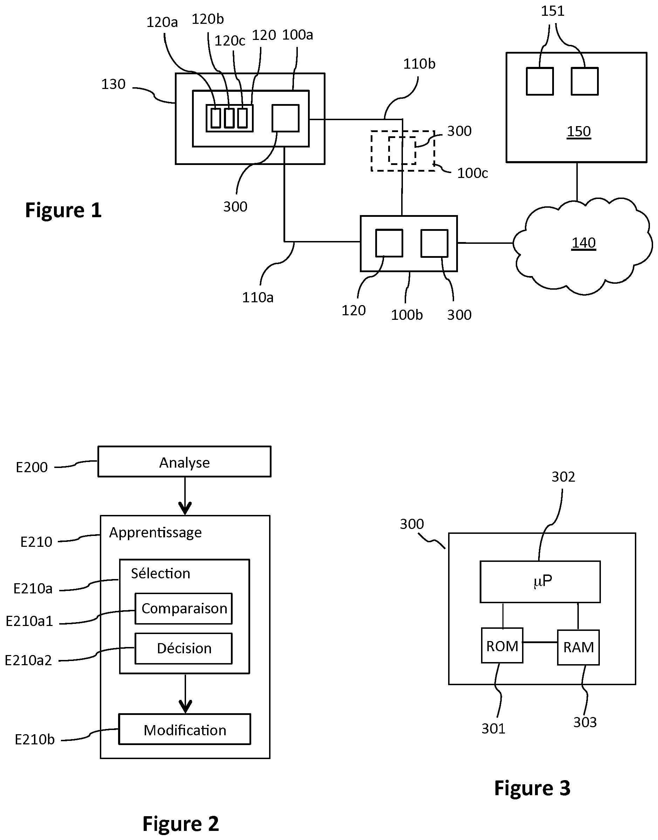

On décrit maintenant, en relation avec la **figure 1**, un système comprenant un dispositif compresseur 100a et un dispositif décompresseur 100b selon un mode de réalisation de la technique décrite.

Selon ce mode de réalisation, le dispositif compresseur 100a et le dispositif décompresseur 100b respectivement compresse et décompresse un premier flux de données transmis via un premier lien de communication 110a.

Le premier lien de communication 110a est du type LPWAN (par exemple un lien radio au standard LoRa®, SIGFOX®, NB-IoT, EC-GPRS, LTE cat-M1, Weightless®, Ingenu/RPMA®, WI-SUN, etc.).

Le dispositif compresseur 100a est embarqué dans un objet connecté 130 (par exemple du type capteur/actionneur) et le dispositif décompresseur 100b est sur le chemin de données entre une passerelle de réseau du réseau LPWAN et un cœur de réseau de communication (par exemple un réseau « IP » tel que le réseau internet 140 ou un réseau intranet).

Les données décompressées par le dispositif décompresseur 100b sont ainsi acheminées jusqu'à un serveur applicatif 150 via le réseau internet 140.

Plus particulièrement, les données décompressées par le dispositif décompresseur 100b sont acheminées jusqu'à une ou plusieurs applications 151 cibles auxquelles les données en question, initialement envoyées par l'objet connecté 130 sous forme compressée par l'action du dispositif compresseur 100a, sont destinées.

Dans certains modes de réalisations non représentés, le dispositif compresseur 100a et le dispositif décompresseur 100b respectivement compresse et décompresse plusieurs premiers flux de données transmis via un ou plusieurs premiers liens de communication 110a.

Dans d'autres modes de réalisations non représentés, chacun des dispositifs compresseur 100a et décompresseur 100b est un dispositif à part entière ou bien est embarqué dans un autre équipement, comme par exemple un objet connecté, un terminal utilisateur du type smartphone ou tablette, une passerelle de réseau ou un cœur de réseau, un serveur ou un ordinateur, un équipement du Cloud Computing (« informatique en nuage »), etc.

Dans encore d'autres modes de réalisation non représentés, les autres équipements en question intègrent chacun à la fois un dispositif compresseur 100a et un dispositif décompresseur 100b. Dans ces configurations le ou les premiers flux de données transmis via le ou les premiers liens de communication 100a sont bidirectionnels. De même, le deuxième flux de données est transmis entre un dispositif compresseur 100a et un dispositif décompresseur 100b de chacun des autres équipements en question.

Dans certains modes de réalisation, le premier lien de communication 110a est un lien radio de courte portée du type Wifl*®*, Bluetooth*®*, IEEE 802.15.4, ZigBee, ou encore un lien cellulaire (par exemple 2G/3G/4G, etc.), etc.

Afin d'optimiser l'utilisation du débit sur le premier lien de communication 110a, des règles de compression/décompression des données (au nombre de trois dans cet exemple, et référencées 120a, 120b et 120c) sont utilisées par les dispositifs compresseur 100a et décompresseur 100b. Ces règles forment un contexte de compression/décompression 120.

Par exemple, les règles de compression/décompression utilisées sont au format SCHC (technique de compression à base de contexte, voir définition plus haut). Le **tableau 1** ci-dessous donne un exemple d'attributs d'une telle règle de compression/décompression au format SCHC (par exemple celle référencée 120a).

**Tableau 1**

| Identificateur de champ | Valeur cible | Opérateur de comparaison | Fonction de compression/décompression |
|---|---|---|---|
| C1 | 0x00 | Ignorer | Ne pas envoyer |
| C2 | 0x1230 | MSB(12) | LSB(4) |
| C3 | 0xABC0 | MSB(12) | LSB(4) |

Plus particulièrement, il apparaît que la règle 120a de compression/décompression en question comprend une liste de trois descriptions de champ. Chaque description de champ correspond à une ligne du tableau 1 ci-dessus et définit un comportement de compression/décompression pour un champ déterminé du premier flux de données à compresser/décompresser.

Plus particulièrement, il apparaît que les attributs de la règle 120a en question sont, pour une description de champ donnée (i.e. pour une ligne donnée du tableau 1) :
- l'identifiant du champ de données (i.e. un champ d'en-têtes, dans le cas d'une description de champ au format SCHC), parmi les données à compresser/décompresser, sur lequel va s'appliquer le cas échéant la fonction de compression/décompression associée à la description en question (ici le champ C1 ou C2 ou C3 de la première colonne suivant la description de champ considérée) ;
- la valeur cible associée au champ identifié par l'identifiant de champ de la première colonne ;
- l'opérateur de comparaison que la règle 120a en question applique entre la valeur effective du champ de données identifié par l'identifiant de la première colonne (i.e. la valeur du champ du premier flux de données en question à compresser ou décompresser) et la valeur cible pour ce champ telle que listée dans la deuxième colonne du tableau ;
- la fonction de compression/décompression à appliquer à la valeur effective du champ de données identifié par l'identifiant de la première colonne lorsque le résultat délivré par l'opérateur de comparaison de la deuxième colonne est positif.

À titre d'exemple, considérons l'application de la règle dont les attributs sont donnés dans le tableau 1 pour compresser le paquet de données composé des trois champs d'en-têtes C1, C2 et C3 et de leurs trois valeurs courantes 0x00, 0x1234 et 0xABCD respectivement, i.e. le paquet de données [0x00,0x1234,0xABCD].

Il apparaît que :
- la valeur courante du champ C1 est ici sans importance, cette valeur étant ignorée par la règle 120a en question. La fonction de compression correspondante est toujours appliquée et les bits de données du champ C1 ne sont pas envoyés dans le cas présent ;
- la valeur courante des 12 MSB (pour « Most Significant Bits » en anglais) du champ C2, i.e. 0x1230, correspond à la valeur cible attendue. La fonction de compression correspondante est donc appliquée et seuls les 4 LSB (pour « Least Significant Bits » en anglais) du champ C2, i.e. 0x4, sont retenus pour être envoyés ;
- la valeur courante des 12 MSB (pour « Most Significant Bits » en anglais) du champ C3, i.e. 0xABC0, correspond à la valeur cible attendue. La fonction de compression correspondante est donc appliquée et seuls les 4 LSB (pour « Least Significant Bits » en anglais) du champ C3, i.e. 0xD, sont retenus pour être envoyés.

De la sorte, l'application de la règle 120a en question au paquet de données [0x00,0x1234,0xABCD] fournit le paquet de données compressées [0x4D] pour envoi par l'objet connecté 130 au serveur applicatif 150 via le premier lien de communication 110a sur lequel se trouve le dispositif décompresseur 100b. Par ailleurs, l'objet connecté 130 envoie simultanément l'identifiant de la règle 120a utilisée par le dispositif compresseur 100a pour effectuer la compression des données transmises.

De la sorte, le dispositif décompresseur 100b applique la même règle 120a aux données compressées qu'il reçoit et effectue les opérations inverses de celles opérées par le dispositif compresseur 100a afin de reconstruire les données d'origine, à savoir :
- association par défaut de la valeur 0x00 au champ C1 ;
- restitution des 12 MSB de 0x1230 concaténés avec le LSB 0x4 reçu via le premier lien de communication 110a de manière à former la valeur courante initiale du champ C2, i.e. 0x1234;
- restitution des 12 MSB de 0xABC0 concaténés avec le LSB 0xD reçu via le premier lien de communication 110a de manière à former la valeur courante initiale du champ C3, i.e. 0xABCD.

Par ailleurs, dans la présente première implémentation, chacun des dispositifs compresseur 100a et décompresseur 100b comprend un dispositif d'apprentissage 300 d'un contexte de compression/décompression. D'autres implémentations possibles sont présentées plus bas.

Un tel dispositif d'apprentissage 300, dont un exemple de structure est décrit ci-dessous en relation avec la figure 3 est apte à obtenir et traiter des données d'un deuxième flux de données transmis entre le dispositif compresseur 100a et le dispositif décompresseur 100b via un deuxième lien de communication 110b.

Par exemple, le deuxième lien de communication 100b est un lien de radiocommunication de courte portée du type Wifl*®*, Bluetooth*®*, IEEE 802.15.4, ZigBee, ou encore un lien cellulaire (par exemple 2G/3G/4G, etc.), etc.

Dans certains modes de réalisations non représentés, le dispositif d'apprentissage 300 est apte à obtenir et traiter des données de plusieurs deuxièmes flux de données transmis entre le dispositif compresseur 100a et le dispositif décompresseur 100b via un ou plusieurs deuxièmes liens de communication 110b.

Dans des variantes, le deuxième lien de communication 110b est un lien du type LPWAN (par exemple un lien radio au standard LoRa®, SIGFOX®, NB-loT, EC-GPRS, LTE cat-M1, Weightless®, Ingenu/RPMA®, WI-SUN, etc.).

Dans d'autres variantes, les premier 110a et deuxième 110b liens de communication sont deux liens radio reposant sur deux modes distincts d'un même protocole de communication radio (par exemple le mode IP du standard NB-loT, et le mode non-IP du même standard (mode non-IP du standard NB-loT connu aussi sous les noms DoNAS, pour « Data over NAS » en anglais, ou NIDD pour « Non-IP Data Delivery » en anglais)).

De la sorte, le ou les dispositifs d'apprentissage 300 sont aptes à mettre en œuvre le procédé d'apprentissage d'un contexte de compression/décompression 120 décrit ci-dessous en relation avec la figure 2.

On décrit maintenant, en relation avec la **figure 2****,** un mode de réalisation d'un procédé d'apprentissage d'un contexte de compression/décompression 120 selon un mode de réalisation de la technique décrite. Ce procédé est exécuté par chaque dispositif d'apprentissage 300 (i.e., dans la présente première implémentation, par celui compris dans le dispositif compresseur 100a et par celui compris dans le dispositif décompresseur 100b).

Lors d'une **étape d'analyse E200,** le dispositif d'apprentissage 300 analyse le deuxième flux de données non compressé, transmis entre le dispositif compresseur 100a et le dispositif décompresseur 100b via le deuxième lien de communication 110b.

Une telle analyse permet au dispositif d'apprentissage 300 d'obtenir des informations nécessaires à l'étape suivante E210 d'apprentissage du contexte de compression/décompression. Ce contexte est lui-même utile pour la compression et décompression ultérieure du premier flux de données à transmettre via le premier lien de communication 110a. La nature des informations en question est décrite ci-dessous en relation avec l'étape d'apprentissage E210 et les sous-étapes correspondantes.

L'étape d'apprentissage E210 comprend une sous-étape de sélection E210a et une sous-étape de modification E210b.

Dans la **sous-étape de sélection E210a,** le dispositif d'apprentissage 300 sélectionne au moins une règle de base parmi une pluralité de règles de base, en fonction du deuxième flux de données non compressé (et plus précisément en fonction des informations obtenues à l'étape d'analyse E200).

Dans un mode de réalisation, de telles règles de base sont par exemple des patrons de règles (ou « templates » en anglais) préalablement implémentés sur le dispositif d'apprentissage 300. Un ou plusieurs de ces patrons de règles sont ainsi sélectionnés puis modifiés par la technique décrite afin de pouvoir être utilisés pour la compression et décompression du premier flux de données échangé sur le premier lien de communication 110a.

Dans un autre mode de réalisation, de telles règles de base sont des règles courantes, déjà utilisées pour la compression et décompression du premier flux de données, mais que l'on veut mettre à jour en utilisant le procédé décrit.

Selon un mode de réalisation particulier, la sélection d'une ou plusieurs des règles de base se fait sur la base de champs de référence définis comme tels pour une règle 120a, 120b, 120c donnée.

Plus particulièrement, chaque description de champ de référence (avec la notion de description de champ telle qu'introduite ci-dessus en relation avec le tableau 1) d'une règle au format SCHC définit un comportement de compression/décompression et une valeur cible pour un champ de référence.

De la sorte, la sélection E210a comprend, pour chacune des règles de base :
- pour chaque description de champ de référence définissant une valeur cible donnée pour un champ de référence donné, une **comparaison E210a1** entre une valeur courante du champ de référence donné dans un paquet du deuxième flux de données, et la valeur cible donnée ; et
- une **décision E210a2** de sélection ou non sélection de la règle de base, en fonction de la comparaison pour chaque description de champ de référence.

Ainsi, chaque règle dont le dispositif d'apprentissage 300 fait l'apprentissage est basée sur une des règles de base, qui est identifiée (i.e. sélectionnée) de manière simple et robuste à travers une comparaison effectuée entre la valeur cible et la valeur courante d'un champ de référence des données sur lequel cette règle doit s'appliquer pour en effectuer la compression ou décompression.

Selon certains modes de réalisation, un champ de référence est un champ d'entête d'un paquet du premier flux de données, transmis via le premier lien de communication 110a, et véhiculant une information statique.

Plus particulièrement, un tel champ de référence est un champ d'en-tête véhiculant une information statique telle que définie par un protocole de communication utilisé sur le premier lien de communication 110a. Il s'agir par exemple du protocole internet IP (e.g. IPv4 ou IPv6), du protocole UDP (pour « User Datagram Protocol » en anglais) ou TCP (pour « Transmission Control Protocol » en anglais), du protocole CoAP (pour « Constrained Application Protocol » en anglais), du protocole MQTT (pour « MQ Telemetry Transport » en anglais) ou WMbus (pour « Wireless M-Bus » en anglais), du protocole ZigBee, etc.

Ainsi, l'identification (i.e. la sélection) d'une ou plusieurs règles parmi les règles de base se fait via la reconnaissance de la valeur d'un champ d'en-tête véhiculant un paramètre statique permettant d'identifier le destinataire final des données compressées échangées dans le premier flux de données via le premier lien de communication 110a (de manière générale, tout champ contenant un élément permettant d'identifier le destinataire final en question peut être considéré pour définir un champ de référence). Ce destinataire final est par exemple le décompresseur 100b, un dispositif dans lequel le décompresseur est embarqué, ou plus particulièrement une application 151 finale à laquelle sont destinées les données après décompression par le décompresseur 100b.

De la sorte, la méthode décrite permet l'apprentissage d'une règle de compression/décompression 120a, 120b, 120c utilisée spécifiquement pour l'échange de données compressées avec un dispositif destinataire particulier.

Par ailleurs l'identification (i.e. la sélection) d'une ou plusieurs parmi les règles de base se fait de manière robuste suivant un critère prédéfini (i.e. suivant un critère connu préalablement à l'établissement de la communication via le premier lien de communication).

La ou les règles sélectionnées (parmi les règles de base) sont modifiées lors de la **sous-étape de modification E210b** pour obtenir la ou les règles de compression/décompression 120a, 120b, 120c comprises dans le contexte de compression/décompression 120.

Selon un mode de réalisation, la modification d'une règle sélectionnée parmi les règles de base se fait sur la base de champs d'adaptation définis comme tels pour une règle de base donnée.

Plus particulièrement, chaque description de champ d'adaptation (avec la notion de description de champ telle qu'introduite ci-dessus en relation avec le tableau 1) d'une règle au format SCHC définit un comportement de compression/décompression et une valeur cible pour un champ d'adaptation.

De la sorte, la modification comprend, pour chaque règle de base sélectionnée et pour chaque description de champ d'adaptation, une modification d'au moins un attribut de la description de champ d'adaptation, en fonction du deuxième flux de données.

Ainsi, le ou les attributs de la règle 120a, 120b, 120c dont on veut faire l'apprentissage sont mis à jour de manière souple via les informations fournies dans le deuxième flux véhiculé par le deuxième lien de communication 110b.

Dans un mode de réalisation, pour au moins un attribut de la description de champ d'adaptation (dont on veut faire l'apprentissage), la modification de cet attribut est effectuée en utilisant directement une valeur courante du champ d'adaptation en question dans un paquet du deuxième flux de données. Par exemple, on prend cette valeur courante comme valeur cible dans la description du champ d'adaptation en question (voir ci-dessous la description du tableau 2).

Dans un autre mode de réalisation, pour au moins un attribut de la description de champ d'adaptation (dont on veut faire l'apprentissage), la modification de cet attribut est fonction d'une valeur courante du champ d'adaptation en question dans un paquet du deuxième flux de données. Par exemple, si la valeur courante est prise comme valeur cible, alors l'opérateur de comparaison et/ou la fonction de compression/décompression changent automatiquement de valeurs, c'est-à-dire basculent vers des nouvelles valeurs prédéterminées (voir ci-dessous la description du tableau 2). Dans ce cas, les nouvelles valeurs prédéterminées des attributs sont prédéfinies dans le dispositif d'apprentissage 300 mettant en œuvre l'étape de modification E230b.

Selon certains modes de réalisation, un champ d'adaptation est un champ d'entête d'un paquet du premier flux de données, transmis via le premier lien de communication 110a, et véhiculant une information dynamique.

Plus particulièrement, un tel champ d'adaptation est un champ d'en-tête véhiculant une information dynamique telle que définie par le protocole de communication utilisé sur le premier lien de communication 110a et décrit ci-dessus en relation avec les champs de référence.

Ainsi, l'apprentissage concerne des attributs (des règles de compression/décompression) associés aux champs d'en-têtes véhiculant un paramètre dynamique (de manière générale, tout champ véhiculant un tel paramètre dynamique peut être considéré afin de définir un champ d'adaptation), i.e. non connu préalablement à l'établissement de la communication sur le premier lien de communication 110a.

Un tel apprentissage permet une adaptation des règles de compression et décompression 120a, 120b, 120c aux changements de paramétrage dynamiques de la communication entre les dispositifs compresseur 100a et décompresseur 100b.

Dans un mode de réalisation particulier, on entend par attributs de la description d'un champ d'adaptation :
- une valeur cible du champ d'adaptation ;
- un opérateur de comparaison entre la valeur cible et une valeur courante du champ d'adaptation dans un paquet du premier flux de données, pour délivrer une décision d'appliquer une fonction de compression ou de décompression à la valeur courante ; et
- la fonction de compression ou de décompression en question.

L'exécution de la sous-étape de modification E210b conclut ainsi l'étape d'apprentissage E210 du procédé d'apprentissage d'un contexte de compression/décompression selon la technique décrite.

Il apparaît que l'apprentissage des règles du contexte de compression/décompression 120 ayant été fait sur la base d'informations véhiculées par le deuxième flux de données non compressé (via la deuxième lien de communication 110b), la bande passante sur le premier lien de communication 110a reste dédiée à l'échange de données utiles.

Par ailleurs, la possibilité d'effectuer l'apprentissage des règles du contexte de compression/décompression 120 sans impacter le débit sur le premier lien de communication 110a permet d'envisager une mise à jour plus fréquente du contexte 120 en question. De la sorte, une adaptation des règles aux re-paramétrages dynamiques de l'échange de données sur le premier lien de communication devient envisageable.

Enfin, lorsque le deuxième lien de communication 110b présente un débit plus élevé que celui du premier lien de communication 110a, la durée de l'apprentissage du contexte de compression par les dispositifs compresseur 100a et décompresseur 100b se trouve réduite.

Par ailleurs, dans certains modes de réalisation, aucune étape de sélection E210a n'est effectuée. L'étape de modification E210b est alors mise en œuvre par défaut pour toutes les règles de base implémentées dans le dispositif d'apprentissage 300 et présentant une valeur cible pour un champ d'adaptation dont une valeur courante est reçue en tant que donnée utile dans le paquet de données reçu via le deuxième lien de communication 100b.

De tels modes de réalisation présentent un intérêt par exemple lorsqu'une seule rège de base est implémentée dans le dispositif d'apprentissage 300. Ce peut être le cas également lorsque le dispositif d'apprentissage 300 en question est implémenté au sein d'un équipement qui n'est connecté, via le premier lien de communication 110a, qu'à un seul destinataire des données compressées. De la sorte, les champs de référence (identifiant ce destinataire unique) sont identiques pour toutes les règles de base, rendant par là-même inutile la mise en œuvre de l'étape de sélection E210a dans son mode de réalisation basé sur une comparaison de champs de référence.

À titre d'exemple, le tableau 2 ci-dessous donne les descriptions de champ, avec les attributs correspondants, d'une règle de compression/décompression de base, au format SCHC, avant apprentissage par la mise en œuvre du procédé d'apprentissage décrit ci-dessus.

On suppose que les champs de référence de cette règle de base sont les champs C2 et C3 (identifiés comme tels par un astérisque dans le tableau 2), cette information étant associée à la règle de base elle-même et donc connue des dispositifs compresseur 100a et décompresseur 100b.

**Tableau 2**

| Identificateur de champ | Valeur cible | Opérateur de comparaison | Fonction de compression/décompression |
|---|---|---|---|
| C1 | | Ignorer | Envoyer |
| C2* | B | Egal | Ne pas envoyer |
| C3* | C | Egal | Ne pas envoyer |
| C4 | X | Egal | Ne pas envoyer |

Considérons que les dispositifs compresseur 100a et décompresseur 100b reçoivent, via le deuxième flux de données non compressé véhiculé par le deuxième lien de communication 100b, un paquet de données dont la partie utile comprend une information, par exemple [C1=A,C2=B,C3=C,C4=D], véhiculant des valeurs courantes associées aux champs C1 à C4. Les champs C1 à C4 sont des champs d'en-têtes du premier flux de données sur lesquels doit s'appliquer la compression et la décompression, effectuées respectivement par le dispositif compresseur 100a et le dispositif décompresseur 100b.

Il apparaît que les valeurs courantes des champs C2 et C3 telles que fournies par le paquet de données, i.e. « B » et « C » respectivement dans le cas présent, correspondent aux valeurs cibles des champs de référence de la règle de base dont les attributs sont donnés dans le tableau 2.

Ainsi, lors de la mise en œuvre de l'étape de sélection E210a du procédé d'apprentissage selon la technique décrite, les dispositifs compresseur 100a et décompresseur 100b sélectionnent la règle de base du tableau 2 (celle-ci va ensuite être modifiée pour obtenir une des règles du contexte).

A contrario, une autre règle de base, dont les champs de référence n'auraient pas de valeur cible correspondant aux valeurs courantes associées aux mêmes champs dans le paquet de données reçu via le deuxième lien de communication 100b, ne serait pas sélectionnée (deux règles de base différentes pouvant avoir par ailleurs des champs de référence différents).

Lors de la mise en œuvre de l'étape de modification E210b du procédé d'apprentissage selon la technique décrite, les dispositifs compresseur 100a et décompresseur 100b modifient (mettent à jour) les attributs de la règle de base préalablement sélectionnée et qui sont associés aux champs d'adaptation dont une valeur courante est reçues en tant que donnée utile dans le paquet de données reçu via le deuxième lien de communication 100b. Dans le cas présent, il s'agit des attributs associés aux champs d'adaptation (aussi appelés champs d'apprentissage) C1 et C4 de la règle de base du tableau 2 (les champs d'apprentissage étant différents des champs de référence dans le cas présent).

De la sorte, les valeurs cibles associées aux champs C1 et C4 de la règle de base du tableau 2 (celle sélectionnée) sont mises à jour vers les valeurs « A » et « D » si l'on se réfère à la valeur des données utiles du paquet de données pris en exemple ci-dessus.

Par ailleurs, la valeur cible du champs courant C1 étant mise à jour vers une valeur non nulle, la valeur de l'opérateur de comparaison associé au champ C1 est également mise à jour avec une valeur prédéfinie pour une valeur non nulle du champ C1, i.e. « Egal » dans le cas présent. De même, la valeur de la fonction de compression/décompression est mise à jour avec une valeur prédéfinie « Ne pas envoyer ».

Dans un autre mode de réalisation, les nouvelles valeurs de l'opérateur de comparaison et de la fonction de compression/décompression sont fournies via les données utiles du paquet de données véhiculé au sein du deuxième flux de données non compressé (par le deuxième lien de communication 110b).

Ainsi, après mise en œuvre du procédé d'apprentissage selon la technique décrite, les attributs de la règle de base du tableau 2 sont mis à jour. Le résultat, formant une des règles du contexte 120, est donné dans le tableau 3 ci-dessous. Par ailleurs, l'identifiant de la règle en question n'est pas modifié.

**Tableau 3**

| Identificateur de champ | Valeur cible | Opérateur de comparaison | Fonction de compression/décompression |
|---|---|---|---|
| C1 | A | Egal | Ne pas envoyer |
| C2* | B | Egal | Ne pas envoyer |
| C3* | C | Egal | Ne pas envoyer |
| C4 | D | Egal | Ne pas envoyer |

La **figure 3** présente enfin un exemple de structure d'un dispositif d'apprentissage 300 permettant la mise en œuvre du procédé de la figure 2. Il comprend une mémoire vive 303 (par exemple une mémoire RAM), une unité de traitement 302, équipée par exemple d'un processeur, et pilotée par un programme d'ordinateur stocké dans une mémoire morte 301 (par exemple une mémoire ROM ou un disque dur). A l'initialisation, les instructions de code du programme d'ordinateur sont par exemple chargées dans la mémoire vive 303 avant d'être exécutées par le processeur de l'unité de traitement 302.

Cette figure 3 illustre seulement une manière particulière, parmi plusieurs possibles, de réaliser l'algorithme détaillé ci-dessus, en relation avec la figure 2. En effet, la technique décrite se réalise indifféremment sur une machine de calcul reprogrammable (un ordinateur PC, un processeur DSP ou un microcontrôleur) exécutant un programme comprenant une séquence d'instructions, ou sur une machine de calcul dédiée (par exemple un ensemble de portes logiques comme un FPGA ou un ASIC, ou tout autre module matériel).

Dans le cas où la technique décrite est implantée sur une machine de calcul reprogrammable, le programme correspondant (c'est-à-dire la séquence d'instructions) pourra être stocké dans un médium de stockage amovible (tel que par exemple une disquette, un CD-ROM ou un DVD-ROM) ou non, ce médium de stockage étant lisible partiellement ou totalement par un ordinateur ou un processeur.

Dans la première implémentation décrite ci-dessus en relation avec les figures 1 à 3, chacun des dispositifs compresseur 100a et décompresseur 100b comprend un dispositif d'apprentissage 300 d'un contexte de compression/décompression (et donc chacun effectue le procédé d'apprentissage de la figure 2). De la sorte, on simplifie la mise en œuvre globale d'un tel apprentissage.

Il est clair cependant que d'autres modes de réalisation de l'invention peuvent être envisagés, sans sortir du cadre de l'invention.

Ainsi, dans une deuxième implémentation, seul l'un des dispositifs compresseur 100a et décompresseur 100b comprend un dispositif d'apprentissage 300 (et donc effectue le procédé d'apprentissage de la figure 2). Dans ce cas, celui des dispositifs compresseur et décompresseur qui n'effectue pas d'apprentissage reçoit le contexte de compression/décompression résultant du procédé d'apprentissage effectué par l'autre.

Dans une troisième implémentation, c'est un dispositif tiers (représenté en pointillé et référencé 100c sur la figure 1) qui comprend un dispositif d'apprentissage 300 (représenté en pointillé sur la figure 1), et donc effectue le procédé d'apprentissage de la figure 2. Dans ce cas, le dispositif compresseur 100a et le dispositif décompresseur 100b reçoivent chacun le contexte de compression/décompression résultant du procédé d'apprentissage effectué par le dispositif tiers 100c.

## Revendications

1. Procédé d'apprentissage d'un contexte de compression/décompression (120) comprenant au moins une règle de compression/décompression (120a, 120b, 120c) destinée à être utilisée par un dispositif compresseur (100a) et un dispositif décompresseur (100b), pour respectivement compresser et décompresser au moins un premier flux de données transmis via au moins un premier lien de communication (110a), **caractérisé en ce qu'**au moins un dispositif, parmi le dispositif compresseur (100a), le dispositif décompresseur (100b) et un dispositif tiers (100c), effectue les étapes suivantes :
• **analyse** (E200) d'au moins un deuxième flux de données non compressé, transmis entre le dispositif compresseur et le dispositif décompresseur via au moins un deuxième lien de communication (110b) ; et
• **apprentissage** (E210) de ladite au moins une règle de compression/décompression, en fonction de ladite analyse ;
**en ce que** ladite étape d'apprentissage comprend une **modification** (E210b) d'au moins une règle de compression/décompression de base, pour obtenir ladite au moins une règle de compression/décompression comprise dans ledit contexte de compression/décompression,
**en ce que** ladite au moins une règle de compression/décompression de base comprend au moins une description de champ d'adaptation définissant un comportement de compression/décompression pour un champ d'adaptation dudit au moins un premier flux de données,
**et en ce que** ladite modification comprend, pour chaque règle de compression/décompression de base sélectionnée :
• pour chaque description de champ d'adaptation, une **modification** d'au moins un attribut de ladite description de champ d'adaptation, en fonction d'une valeur courante dudit champ d'adaptation dans un paquet dudit au moins un deuxième flux de données.

2. Procédé selon la revendication 1, dans lequel ledit au moins un champ d'adaptation est un champ d'en-tête d'un paquet dudit au moins un premier flux de données, ledit champ d'en-tête véhiculant une information dynamique d'un protocole de communication.

3. Procédé selon l'une quelconque des revendications 1 et 2, dans lequel ledit au moins un attribut de ladite au moins une description de champ d'adaptation appartient au groupe comprenant :
• une valeur cible dudit champ d'adaptation ;
• un opérateur de comparaison entre ladite valeur cible et une valeur courante dudit champ d'adaptation dans un paquet dudit au moins un premier flux de données, pour délivrer une décision d'appliquer une fonction de compression ou de décompression à ladite valeur courante ; et
• ladite fonction de compression ou de décompression.

4. Procédé selon l'une quelconque des revendications 1 à 3, dans lequel ladite étape d'apprentissage comprend une **sélection** (E210a), en fonction dudit au moins un deuxième flux de données non compressé, de ladite au moins une règle de compression/décompression de base parmi une pluralité de règles de compression/décompression de base,
dans lequel chacune des règles de compression/décompression de base comprend au moins une description de champ de référence définissant un comportement de compression/décompression et une valeur cible pour un champ de référence dudit au moins un premier flux de données,
et dans lequel ladite sélection comprend, pour chacune des règles de compression/décompression de base :
• pour chaque description de champ de référence définissant une valeur cible donnée pour un champ de référence donné, une **comparaison** (E210a1) entre une valeur courante dudit champ de référence donné dans un paquet dudit au moins un deuxième flux de données, et ladite valeur cible donnée ; et
• une **décision** (E210a2) de sélection ou non sélection de ladite règle de compression/décompression de base, en fonction de ladite comparaison pour chaque description de champ de référence.

5. Procédé selon la revendication 4, dans lequel ledit au moins un champ de référence est un autre champ d'en-tête d'un paquet dudit au moins un premier flux de données, ledit autre champ d'en-tête véhiculant une information statique d'un protocole de communication, ou dudit protocole de communication quand la revendication 5 est rattachée à la revendication 2.

6. Procédé selon l'une quelconque des revendications 1 à 5, dans lequel ladite au moins une règle de compression, comprise dans ledit contexte de compression/décompression, est au format SCHC (pour « Static Context Header Compression » en anglais).

7. Procédé selon l'une quelconque des revendications 1 à 6, dans lequel ledit au moins un premier lien de communication est un lien d'un réseau sans fil à longue portée et basse consommation (LPWAN, pour « Low-Power Wide-Area Network » en anglais).

8. Procédé selon l'une quelconque des revendications 1 à 7, dans lequel ledit au moins un deuxième lien de communication est un lien d'un réseau sans fil cellulaire.

9. Procédé selon l'une quelconque des revendications 1 à 8, dans lequel le dispositif compresseur et le dispositif décompresseur effectuent chacun les étapes d'analyse et d'apprentissage.

10. Procédé selon l'une quelconque des revendications 1 à 8, dans lequel l'un des dispositifs compresseur et décompresseur effectue les étapes d'analyse et d'apprentissage, et en ce que l'autre des dispositifs compresseur et décompresseur reçoit le contexte de compression/décompression résultant desdites étapes d'analyse et d'apprentissage.

11. Procédé selon l'une quelconque des revendications 1 à 8, dans lequel le dispositif tiers effectue les étapes d'analyse et d'apprentissage, et en ce que le dispositif compresseur et le dispositif décompresseur reçoivent chacun le contexte de compression/décompression résultant desdites étapes d'analyse et d'apprentissage.

12. Produit programme d'ordinateur comprenant des instructions de code de programme pour la mise en œuvre d'un procédé selon l'une quelconque des revendications 1 à 11, lorsque ledit programme est exécuté sur un ordinateur.

13. Dispositif d'apprentissage (300) d'un contexte de compression/décompression (120) comprenant au moins une règle de compression/décompression (120a, 120b, 120c) destinée à être utilisée par un dispositif compresseur (100a) et un dispositif décompresseur (100b), pour respectivement compresser et décompresser au moins un premier flux de données transmis via au moins un premier lien de communication (110a), **caractérisé en ce qu'**il comprend une machine de calcul reprogrammable (302) ou une machine de calcul dédiée, apte à et configurée pour :
• analyser d'au moins un deuxième flux de données non compressé, transmis entre le dispositif compresseur et le dispositif décompresseur via au moins un deuxième lien de communication (110b) ; et
• faire l'apprentissage de ladite au moins une règle de compression/décompression, en fonction de ladite analyse ;
ledit apprentissage comprenant une **modification** (E210b) d'au moins une règle de compression/décompression de base, pour obtenir ladite au moins une règle de compression/décompression comprise dans ledit contexte de compression/décompression,
ladite au moins une règle de compression/décompression de base comprenant au moins une description de champ d'adaptation définissant un comportement de compression/décompression pour un champ d'adaptation dudit au moins un premier flux de données,
ladite modification comprenant, pour chaque règle de compression/décompression de base sélectionnée :
• pour chaque description de champ d'adaptation, une **modification** d'au moins un attribut de ladite description de champ d'adaptation, en fonction d'une valeur courante dudit champ d'adaptation dans un paquet dudit au moins un deuxième flux de données.

## Patentansprüche

1. Verfahren zum Lernen eines Kompressions-/Dekompressionskontextes (120), der mindestens eine Kompressions-/Dekompressionsregel (120a, 120b, 120c) zur Nutzung durch eine Kompressionsvorrichtung (100a) und eine Dekompressionsvorrichtung (100b) umfasst, zum jeweiligen Komprimieren und Dekomprimieren mindestens eines ersten Datenstroms, der über mindestens eine erste Kommunikationsverbindung (110a) übertragen wird, **dadurch gekennzeichnet, dass** mindestens eine Vorrichtung aus der Kompressionsvorrichtung (100a), der Dekompressionsvorrichtung (100b) und einer Drittvorrichtung (100c) die folgenden Schritte durchführt:
• Analysieren (E200) mindestens eines zweiten unkomprimierten Datenstroms, der zwischen der Kompressionsvorrichtung und der Dekompressionsvorrichtung über mindestens eine zweite Kommunikationsverbindung (110b) übertragen wird; und
• Lernen (E210) der mindestens einen Kompressions-/Dekompressionsregel in Abhängigkeit von der Analyse;
dadurch, dass der Lernschritt eine Modifikation (E210b) von mindestens einer Kompressions-/Dekompressionsgrundregel umfasst, um die mindestens eine in dem Kompressions-/Dekompressionskontext umfasste Kompressions-/Dekompressionsregel zu erhalten,
dadurch, dass die mindestens eine Kompressions-/Dekompressionsgrundregel mindestens eine Anpassungsfeldbeschreibung umfasst, die ein Kompressions-/Dekompressionsverhalten für ein Anpassungsfeld des mindestens einen ersten Datenstroms definiert,
und dadurch, dass die Modifikation für jede ausgewählte Kompressions-/Dekompressionsgrundregel Folgendes umfasst:
• für jede Anpassungsfeldbeschreibung eine Modifikation von mindestens einem Attribut der Anpassungsfeldbeschreibung in Abhängigkeit von einem aktuellen Wert des Anpassungsfeldes in einem Paket des mindestens einen zweiten Datenstroms.

2. Verfahren nach Anspruch 1, wobei das mindestens eine Anpassungsfeld ein Header-Feld eines Pakets des mindestens einen ersten Datenstroms ist, wobei das Header-Feld eine dynamische Information eines Kommunikationsprotokolls führt.

3. Verfahren nach einem der Ansprüche 1 oder 2, wobei das mindestens eine Attribut der mindestens einen Anpassungsfeldbeschreibung zu der Gruppe gehört, die Folgendes umfasst:
• einen Zielwert des Anpassungsfeldes;
• einen Vergleichsoperator zwischen dem Zielwert und einem aktuellen Wert des Anpassungsfeldes in einem Paket des mindestens einen ersten Datenstroms, um eine Entscheidung zur Anwendung einer Kompressions- oder Dekompressionsfunktion auf den aktuellen Wert zu liefern; und
• die Kompressions- oder Dekompressionsfunktion.

4. Verfahren nach einem der Ansprüche 1 bis 3, wobei der Lernschritt Auswählen (E210a), in Abhängigkeit von dem mindestens einen zweiten unkomprimierten Datenstrom, der mindestens einen Kompressions-/Dekompressionsgrundregel aus einer Vielzahl von Kompressions-/Dekompressionsgrundregeln umfasst,
wobei jede der Kompressions-/Dekompressionsgrundregeln mindestens eine Referenzfeldbeschreibung umfasst, die ein Kompressions-/Dekompressionsverhalten und einen Zielwert für ein Referenzfeld des mindestens einen ersten Datenstroms definiert,
und wobei das Auswählen für jede der Kompressions-/Dekompressionsgrundregeln Folgendes umfasst:
• Anstellen eines Vergleichs (E210a1), für jede Referenzfeldbeschreibung, die einen gegebenen Zielwert für ein gegebenes Referenzfeld definiert, zwischen einem aktuellen Wert des gegebenen Referenzfeldes in einem Paket des mindestens einen zweiten Datenstroms und dem gegebenen Zielwert; und
• Treffen einer Entscheidung (E210a2) über das Auswählen oder Nichtauswählen der Kompressions-/Dekompressionsgrundregel in Abhängigkeit von dem Vergleich für jede Referenzfeldbeschreibung.

5. Verfahren nach Anspruch 4, wobei das mindestens eine Referenzfeld ein weiteres Header-Feld eines Pakets des mindestens einen ersten Datenstroms ist, wobei das andere Header-Feld eine statische Information eines Kommunikationsprotokolls oder des Kommunikationsprotokolls führt, wenn sich Anspruch 5 auf Anspruch 2 bezieht.

6. Verfahren nach einem der Ansprüche 1 bis 5, wobei die mindestens eine in dem Kompressions-/Dekompressionskontext umfasste Kompressionsregel im SCHC-(Static Context Header Compression)-Format vorliegt.

7. Verfahren nach einem der Ansprüche 1 bis 6, wobei die mindestens eine erste Kommunikationsverbindung eine Verbindung eines drahtlosen Low-Power Wide-Area Network (LPWAN) ist.

8. Verfahren nach einem der Ansprüche 1 bis 7, wobei die mindestens eine zweite Kommunikationsverbindung eine Verbindung eines drahtlosen Mobilfunknetzes ist.

9. Verfahren nach einem der Ansprüche 1 bis 8, wobei die Kompressionsvorrichtung und die Dekompressionsvorrichtung jeweils die Analyse- und Lernschritte durchführen.

10. Verfahren nach einem der Ansprüche 1 bis 8, wobei eine aus der Kompressions- oder Dekompressionsvorrichtung die Analyse- und Lernschritte durchführt und die andere aus der Kompressions- und der Dekompressionsvorrichtung den aus den Analyse- und Lernschritten resultierenden Kompressions-/Dekompressionskontext empfängt.

11. Verfahren nach einem der Ansprüche 1 bis 8, wobei die Drittvorrichtung die Analyse- und Lernschritte durchführt und wobei die Kompressionsvorrichtung und die Dekompressionsvorrichtung jeweils den aus den Analyse- und Lernschritten resultierenden Kompressions-/Dekompressionskontext empfangen.

12. Computerprogrammprodukt, das Programmcodebefehle umfasst, zum Durchführen eines Verfahrens nach einem der Ansprüche 1 bis 11, wenn das Programm auf einem Computer durchgeführt wird.

13. Lernvorrichtung (300) für einen Kompressions-/Dekompressionskontext (120), der mindestens eine Kompressions-/Dekompressionsregel (120a, 120b, 120c) zur Nutzung durch eine Kompressionsvorrichtung (100a) und eine Dekompressionsvorrichtung (100b) umfasst, zum jeweiligen Komprimieren und Dekomprimieren mindestens eines über mindestens eine erste Kommunikationsverbindung (110a) übertragenen ersten Datenstroms, **dadurch gekennzeichnet, dass** sie eine umprogrammierbare Rechenmaschine (302) oder eine dedizierte Rechenmaschine umfasst, die in der Lage und konfiguriert ist zum:
• Analysieren mindestens eines zweiten unkomprimierten Datenstroms, der zwischen der Kompressionsvorrichtung und der Dekompressionsvorrichtung über mindestens eine zweite Kommunikationsverbindung (110b) übertragen wird; und
• Lernen mindestens einer Kompressions-/Dekompressionsregel in Abhängigkeit von der Analyse;
wobei das Lernen eine Modifikation (E210b) von mindestens einer Kompressions-/Dekompressionsgrundregel umfasst, um die mindestens eine in dem Kompressions-/Dekompressionskontext umfasste Kompressions-/Dekompressionsregel zu erhalten,
wobei die mindestens eine Kompressions-/Dekompressionsgrundregel mindestens eine Anpassungsfeldbeschreibung umfasst, die ein Kompressions-/Dekompressionsverhalten für ein Anpassungsfeld des mindestens einen ersten Datenstroms definiert,
wobei die Modifikation für jede ausgewählte Kompressions-/Dekompressionsgrundregel Folgendes umfasst:
• für jede Anpassungsfeldbeschreibung eine Modifikation von mindestens einem Attribut der Anpassungsfeldbeschreibung in Abhängigkeit von einem aktuellen Wert des Anpassungsfeldes in einem Paket des mindestens einen zweiten Datenstroms.

## Claims

1. A method for learning a compression/decompression context (120) comprising at least one compression/decompression rule (120a, 120b, 120c) intended to be used by a compressor device (100a) and a decompressor device (100b), for respectively compressing and decompressing at least one first data flow transmitted via at least one first communication link (110a), **characterised in that** at least one device, from among the compressor device (100a), the decompressor device (100b) and a third party device (100c), carries out the following steps of:
• analysing (E200) at least one second non-compressed data flow transmitted between the compressor device and the decompressor device via at least one second communication link (110b); and
• learning (E210) said at least one compression/decompression rule as a function of said analysis;
**in that** said learning step comprises a modification (E210b) of at least one basic compression/decompression rule in order to obtain said at least one compression/decompression rule comprised within said compression/decompression context,
**in that** said at least one basic compression/decompression rule comprises at least one adaptation field description defining a compression/decompression behaviour for an adaptation field of said at least one first data flow,
and **in that** said modification comprises, for each selected basic compression/decompression rule:
• for each adaptation field description, a modification of at least one attribute of said adaptation field description, as a function of a current value of said adaptation field in a packet of said at least one second data flow.

2. The method according to claim 1, wherein said at least one adaptation field is a header field of a packet of said at least one first data flow, said header field carrying a piece of dynamic information of a communication protocol.

3. The method according to any one of claims 1 and 2, wherein said at least one attribute of said at least one adaptation field description belongs to the group comprising:
• a target value of said adaptation field;
• a comparison operator between said target value and a current value of said adaptation field in a packet of said at least one first data flow, for delivering a decision for applying a compression or decompression function to said current value; and
• said compression or decompression function.

4. The method according to any one of claims 1 to 3, wherein said learning step comprises a selection (E210a), as a function of said at least one second non-compressed data flow, of said at least one basic compression/decompression rule from among a plurality of basic compression/decompression rules,
wherein each of the basic compression/decompression rules comprises at least one reference field description defining a compression/decompression behaviour and a target value for a reference field of said at least one first data flow,
and wherein said selection comprises, for each of the basic compression/decompression rules:
• for each reference field description defining a given target value for a given reference field, a comparison (E210a1) between a current value of said given reference field in a packet of said at least one second data flow, and said given target value; and
• a decision (E210a2) for selecting or not selecting said basic compression/decompression rule, as a function of said comparison for each reference field description.

5. The method according to claim 4, wherein said at least one reference field is another header field of a packet of said at least one first data flow, said other header field carrying a piece of static information of a communication protocol, or of said communication protocol when claim 5 is linked to claim 2.

6. The method according to any one of claims 1 to 5, wherein said at least one compression rule comprised within said compression/decompression context, is in the SCHC ("Static Context Header Compression") format.

7. The method according to any one of claims 1 to 6, wherein said at least one first communication link is a link of a wireless low-power wide-area network (LPWAN).

8. The method according to any one of claims 1 to 7, wherein said at least one second communication link is a link of a cellular wireless network.

9. The method according to any one of claims 1 to 8, wherein the compressor device and the decompressor device each carry out the analysis and learning steps.

10. The method according to any one of claims 1 to 8, wherein one of the compressor and decompressor devices carries out the analysis and learning steps, and in that the other one of the compressor and decompressor devices receives the compression/decompression context resulting from said analysis and learning steps.

11. The method according to any one of claims 1 to 8, wherein the third party device carries out the analysis and learning steps, and in that the compressor device and the decompressor device each receive the compression/decompression context resulting from said analysis and learning steps.

12. A computer program product comprising program code instructions for implementing a method according to any one of claims 1 to 11, when said program is executed on a computer.

13. A device (300) for learning a compression/decompression context (120) comprising at least one compression/decompression rule (120a, 120b, 120c) intended to be used by a compressor device (100a) and a decompressor device (100b), for respectively compressing and decompressing at least one first data flow transmitted via at least one first communication link (110a), **characterised in that** it comprises a reprogrammable computation machine (302), or a dedicated computation machine, that is able to and configured to:
• analyse at least one second non-compressed data flow transmitted between the compressor device and the decompressor device via at least one second communication link (110b); and
• learn said at least one compression/decompression rule as a function of said analysis;
said learning comprising a modification (E210b) of at least one basic compression/decompression rule in order to obtain said at least one compression/decompression rule comprised within said compression/decompression context,
said at least one basic compression/decompression rule comprising at least one adaptation field description defining a compression/decompression behaviour for an adaptation field of said at least one first data flow,
said modification comprising, for each selected basic compression/decompression rule:
• for each adaptation field description, a modification of at least one attribute of said adaptation field description, as a function of a current value of said adaptation field in a packet of said at least one second data flow.
